# EUROPÄISCHE PATENTSCHRIFT

(11) **EP 1 736 354 B1**
(45) Veröffentlichungstag und Bekanntmachung des Hinweises auf die Patenterteilung: **01.12.2010**
(21) Anmeldenummer: 06114608.0
(22) Anmeldetag: 29.05.2006
(51) Int. Cl.: B60K 37/06, H03K 17/975

(54) **Bedienelement mit Näherungssensor**
Operating element with proximity sensor
Organe de commande à détecteur de proximité

(30) Priorität: 24.06.2005 DE 102005029512
(43) Veröffentlichungstag der Anmeldung: 27.12.2006
(73) Patentinhaber: Continental Automotive GmbH, 30165 Hannover (DE)
(72) Erfinder: Born, Frank, 61239 Ober-Mörlen (DE); Mankel, Norbert, 35043 Marburg (DE); Reinhardt, Jörg, 35633 Lahnau (DE); Schäfer, Stefan, 35578 Wetzlar (DE); Wüstenbecker, Dirk, 35614 Aßlar (DE)

(56) Entgegenhaltungen:
- US-A- 5 889 507
- US-A1- 2003 169 231

## Beschreibung

Die Erfindung betrifft ein Bedienelement, insbesondere für eine Kraftfahrzeugkomponente mit einem beweglich in einem Trägerelement gelagerten Betätigungselement, das insbesondere auf ein Schaltelement einwirkt, wobei in dem Betätigungselement ein elektrisch leitendes Sensorelement eines kapazitiven Näherungssensors angeordnet ist, das in einer Ruheposition des Betätigungselements elektrisch leitend mit einer Leiterplatte verbunden ist, und es sich bei dem Bedienelement um einen Drucktaster handelt. Ein derartiges Bedienelement ist aus der US 2003/0169231 A1 bekannt.

Zur Bedienung von Kraftfahrzeugkomponenten, wie zum Beispiel eines Radiogerätes, eines Navigationsgerätes, eines Autotelefons, einer Multimediaanlage und dergleichen, werden häufig Bedien- und Anzeigeeinrichtungen eingesetzt, die im Fahrzeug ergonomisch angeordnet sind. Die Anzeigeeinrichtung sollte dabei so angeordnet werden, dass der Fahrer diese mit einer möglichst geringen Ablenkung vom Straßenverkehr erfassen kann. Die Anzeigeeinheit wird daher vorzugsweise im Bereich des Armaturenbrettes oder im oberen Bereich einer Mittelkonsole angeordnet. Die Bedieneinheit wird vorzugsweise so angeordnet, dass der Fahrer diese mit den Fingern ohne größere Armbewegung erreichen kann. Diese Anordnung der Bedieneinheit hat jedoch den Nachteil, dass die Bedieneinheit optisch nur sehr schlecht erfasst werden kann. Der Fahrer wird daher die Bedienelemente der Bedieneinheit häufig ohne Sichtkontakt ertasten und auswählen. Es ist daher wünschenswert, die Annäherung einer Hand des Fahrers an ein Bedienelement zu erfassen, um so beispielsweise in der Anzeigeeinrichtung einen Hinweis auf die Art des Bedienelementes bzw. die damit zu bedienende Funktion oder auch eine akustische Rückmeldung ausgeben zu können, bevor das Bedienelement betätigt und die damit verknüpfte Aktion ausgeführt wurde.

Aufgabe der Erfindung ist es daher, ein Bedienelement derart weiterzubilden, dass eine Annäherung an das Bedienelement erkannt wird, gleichzeitig jedoch die herkömmliche Funktionalität eines Bedienelementes, insbesondere eines Drucktasters, nicht beeinträchtigt wird.

Die Aufgabe wird durch ein Bedienelement mit den Merkmalen des Anspruchs 1 gelöst.

In dem Betätigungselement des Bedienelementes ist ein elektrisch leitendes Sensorelement (Sensorelektrode) eines kapazitiven Näherungssensors angeordnet, das elektrisch leitend mit einer Leiterplatte verbunden ist. Durch die Anordnung des Sensorelementes in dem Betätigungselement ist das Sensorelement für den Benutzer nicht sichtbar und beeinträchtigt somit in keiner Weise das optische Erscheinungsbild des Bedienelementes. Durch die entsprechende elektrisch leitende Verbindung des Sensorelementes mit der Leiterplatte kann ein Sensorsignal des Sensorelementes in einfacher Weise zu signalverarbeitenden Elementen weitergeleitet werden, die insbesondere auf der Leiterplatte selbst angeordnet sind. Durch geeignete Anordnung des Sensorelementes in dem Betätigungselement und geeignete Verbindung mit der Leiterplatte kann erreicht werden, dass die herkömmliche Funktionalität des Bedienelementes, insbesondere eines Drucktasters, nicht beeinträchtigt wird.

Das Sensorelement kann einen mit einer metallischen Beschichtung versehenen Teilbereich aufweisen, der durch die Leiterplatte hindurchragt und in einer Ruheposition des Drucktasters an einer leitfähigen Fläche einer dem Betätigungselement abgewandten Seite der Leiterplatte anliegt. Das Sensorelement und gegebenenfalls auch ein zusätzliches Element zur Feldausrichtung werden hierbei über ein Zweikomponentenbetätigungselement mit teilweise metallischer Beschichtung realisiert. Die elektrische Anbindung des Sensorelementes an die Leiterplatte erfolgt dabei ebenfalls über den metallisch beschichteten Bereich des Betätigungselementes. Das Betätigungselement und das Sensorelement sind somit einstückig ausgebildet, so dass zusätzlicher Montageaufwand nicht erforderlich ist.

In einer weiteren Ausgestaltung kann das Schaltelement eine auf der Schalterplatte angeordnete Schaltmatte beinhalten, das Sensorelement als metallische Beschichtung auf das Betätigungselement aufgebracht sein und die Schaltmatte eine elektrisch leitfähige Schicht aufweisen, die sowohl mit der leitfähigen Beschichtung des Betätigungselementes als auch mit der Leiterplatte verbunden ist. Durch die Verwendung eines elektrisch leitfähigen Kunststoffmaterials für Teilbereiche des Betätigungselementes und einer hiermit in Verbindung stehenden leitfähigen Beschichtung einer Schaltmatte als Schaltelement kann auf einfache Weise eine leitfähige Verbindung zwischen dem Sensorelement und der Leiterplatte realisiert werden. Insbesondere kann bei dieser Ausgestaltung das Betätigungselement die Schaltmatte hintergreifen, wobei die leitfähige Beschichtung des Betätigungselementes in einer Ruheposition des Bedienelementes an der elektrisch leitfähigen Schicht der Schaltmatte anliegt. Die Schaltmatte dient hier gleichzeitig als Anschlag des Betätigungselementes in der Ruheposition, wobei durch deren gummiartiges Material gleichzeitig eine Geräuschdämpfung beim Zurückschnellen der Taste von der Betätigungsposition in die Ruheposition gewährleistet ist.

Die Erfindung wird nachfolgend anhand von Ausführungsbeispielen und der Zeichnung näher erläutert. Es zeigen:
- Figur 1: eine Ausgestaltung eines Drucktasters, bei dem das Sensorelement durch die Leiterplatte hindurchragt,
- Figur 2: eine weitere Ausgestaltung eines Drucktasters.

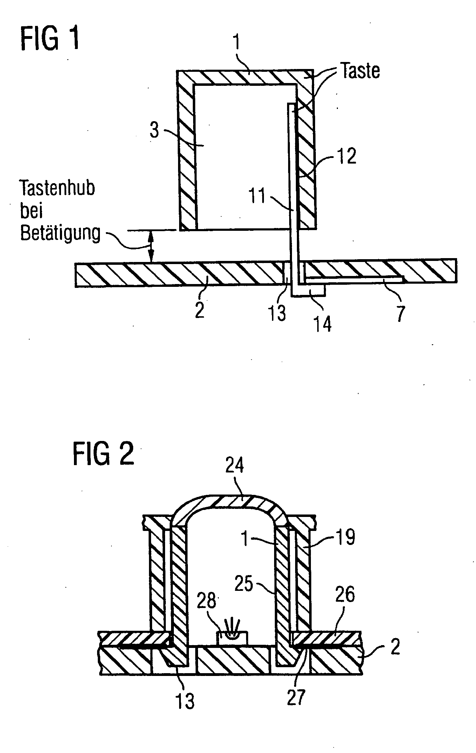

Figur 1 zeigt schematisch eine Ausgestaltung eines Drucktasters, wobei das Sensorelement als mit einer metallischen Beschichtung 11 versehener Teilbereich 12 des Betätigungselementes 1 ausgebildet ist. Der Teilbereich 12 ragt durch eine Öffnung 13 der Leiterplatte 2 hindurch und liegt mit einem abgewinkelten Ende 14 an einer leitfähigen Fläche 7 der Leiterplatte 2 an, wobei die leitfähige Fläche 7 auf die dem Betätigungselement 1 abgewandte Seite der Leiterplatte 2 aufgebracht ist. Durch die leitfähige Beschichtung 11 des Teilbereiches 12 des Betätigungselementes 1 wird somit zum einen das Sensorelement selbst realisiert und zum anderen auch die sichere Kontaktierung mit der leitfähigen Fläche 7 der Leiterplatte 2 in der Ruheposition des Betätigungselementes 1 gewährleistet. In einer Betätigungsposition des Betätigungselementes 1 besteht hingegen kein Kontakt zwischen dem Sensorelement und der Leiterplatte. Dies ist jedoch auch nicht erforderlich, da zu diesem Zeitpunkt eine Annäherung nicht detektiert werden muss. Durch die teilweise Metallisierung des Betätigungselementes 1 und die Nutzung dieser metallisierten Fläche sowohl für das Sensorelement als auch für eine Ausrichtung des Feldes kann die Gesamtsensorik sehr Platz sparend realisiert werden. Insbesondere wird bei dieser Ausgestaltung der Innenraum 3 durch das zusätzlich Anbringen des Sensorelementes für den kapazitiven Näherungssensor nur geringfügig beeinträchtigt und steht daher nahezu unvermindert für das Einbringen von Beleuchtungselementen und dergleichen zur Verfügung.

Figur 2 zeigt eine weitere Ausgestaltung, bei der das Betätigungselement einen nicht leitfähigen Teilbereich 24 und einen leitfähigen Teilbereich 25 aufweist. Auf der Leiterplatte 2 ist eine Schaltmatte 26 angeordnet, die auf ihrer der Leiterplatte 2 zugewandten Seite eine elektrisch leitfähige Oberflächenbeschichtung 27 aufweist. Der leitfähige Teilbereich 25 des Betätigungselementes 1 liegt nun ebenfalls an dieser leitfähigen Oberflächenbeschichtung 27 der Schaltmatte 26 an, so dass durch die leitfähige Oberflächenbeschichtung der Schaltmatte 26 eine Kontaktierung zwischen dem als Sensorelement wirkenden leitfähigen Teilbereich 25 des Betätigungselementes 1 und der Leiterplatte 2 in der Ruheposition des Betätigungselementes 1 gewährleistet ist. Das Betätigungselement 1 ragt bei dieser Ausführungsform in eine Öffnung 13 der Leiterplatte 2 hinein. Mittels einer LED 28, die auf der Leiterplatte 2 angebracht ist, ist wiederum eine Beleuchtung des Bedienelementes möglich.

Anhand verschiedener Beispiele wurde gezeigt, wie ein durch einen elektrisch leitfähigen Bereich eines Betätigungselementes gebildetes Sensorelement eines kapazitiven Näherungssensors mit einer Leiterplatte sicher kontaktiert werden kann, wobei das Sensorelement ebenfalls so vorteilhaft ausgebildet ist, dass es die Integration weiterer Komponenten in das Betätigungselement möglichst wenig behindert bzw. zusätzlich die Funktion weiterer Komponenten einer Drucktaste wahrnimmt.

## Patentansprüche

1. Bedienelement, insbesondere für eine Kraftfahrzeugkomponente, mit einem linear beweglich in einem Trägerelement gelagerten Betätigungselement (1), das insbesondere auf ein Schaltelement einwirkt, wobei in dem Betätigungselement (1) ein elektrisch leitendes Sensorelement eines kapazitiven Näherungssensors angeordnet ist, das in einer Ruheposition des Betätigungselements (1) elektrisch leitend mit einer Leiterplatte (2) verbunden ist, und es sich bei dem Bedienelement um einen Drucktaster handelt **dadurch gekennzeichnet, dass** in einer Betätigungsposition des Betätigungselements (1) kein elektrisch leitender Kontakt zwischen dem Sensorelement und der Leiterplatte (2) besteht.

2. Bedienelement nach Anspruch 1, **dadurch gekennzeichnet, dass** das Sensorelement als mit einer metallischen Beschichtung (11) versehener Teilbereich (12) des Betätigungselements (1) ausgebildet ist, der durch die Leiterplatte (2) hindurchragt und in einer Ruheposition des Betätigungselements an einer leitfähigen Fläche (7) einer dem Betätigungselement (1) abgewandten Seite der Leiterplatte (2) anliegt.

3. Bedienelement nach Anspruch 1, **dadurch gekennzeichnet, dass**
- das Schaltelement eine auf der Leiterplatte angeordnete Schaltmatte (26) beinhaltet,
- das Sensorelement als leitfähiger Teilbereich (25) des Betätigungselements (1) ausgebildet ist,
- die Schaltmatte (26) eine elektrisch leitfähige Schicht (27) aufweist, die sowohl mit dem leitfähigen Teilbereich (25) des Betätigungselements (1) als auch mit der Leiterplatte (2) verbunden ist.

4. Bedienelement nach Anspruch 3, **dadurch gekennzeichnet, dass** das Betätigungselement (1) die Schaltmatte (26) hintergreift und der leitfähige Teilbereich (25) des Betätigungselements (1) in der Ruheposition des Bedienelements an der elektrisch leitfähigen Schicht (27) der Schaltmatte (26) anliegt.

## Claims

1. Control element, particularly for a motor vehicle component, having an operating element (1) which is mounted so as to move linearly in a support element and which acts on a switching element, in particular, wherein an electrically conductive sensor element in a capacitive proximity sensor is arranged in the operating element (1) and is electrically conductively connected to a printed circuit board (2) in a position in which the operating element (1) is at rest, and the control element is a pushbutton switch, **characterized in that** there is no electrically conductive contact between the sensor element and the printed circuit board (2) in an operating position of the operating element (1).

2. Control element according to Claim 1, **characterized in that** the sensor element is in the form of a subregion (12) of the operating element (1), which subregion is provided with a metal coating (11), projects through the printed circuit board (2) and, in a position in which the operating element is at rest, bears against a conductive face (7) of a side of the printed circuit board (2) which is remote from the operating element (1).

3. Control element according to Claim 1, **characterized in that**
- the switching element contains a switching mat (26) arranged on the printed circuit board,
- the sensor element is in the form of a conductive subregion (25) of the operating element (1),
- the switching mat (26) has an electrically conductive layer (27) which is connected both to the conductive subregion (25) of the operating element (1) and to the printed circuit board (2).

4. Control element according to Claim 3, **characterized in that** the operating element (1) engages behind the switching mat (26), and the conductive subregion (25) of the operating element (1), in a position in which the control element is at rest, bears against the electrically conductive layer (27) of the switching mat (26).

## Revendications

1. Organe de commande, notamment pour un composant de véhicule automobile, comportant un organe d'actionnement (1) monté, en lui permettant un déplacement linéaire, dans un organe support, ledit organe d'actionnement agissant notamment sur un organe commutant, où, dans l'organe d'actionnement (1), est placé un organe détecteur à conduction électrique d'un détecteur de proximité capacitif qui est, dans une position de repos de l'organe d'actionnement (1), relié en conduction électrique à une carte à circuits imprimés (2) et où l'organe de commande est une touche à pression, **caractérisé** p a r le fait que, dans une position actionnée de l'organe d'actionnement (1), il n'y a pas de contact à conduction électrique entre l'organe détecteur et la carte à circuits imprimés (2).

2. Organe de commande selon la revendication 1, **caractérisé par le fait que** l'organe détecteur est conçu en tant que partie (12) de l'organe d'actionnement (1) dotée d'un couche métallique (11), laquelle partie fait saillie à travers la carte à circuits imprimés (2) et, dans une position de repos de l'organe d'actionnement, est appliquée sur une surface conductible (7) d'une face de la carte à circuits imprimés (2) opposée à l'organe d'actionnement (1).

3. Organe de commande selon la revendication 1, **caractérisé par le fait que**
- l'organe commutant contient un tapis de commutation (26) placé sur la carte à circuits imprimés,
- l'organe détecteur est conçu comme partie conductible (25) de l'organe d'actionnement (1),
- le tapis de commutation (26) comporte une couche (27) conduisant l'électricité qui est reliée aussi bien à la partie conductible (25) de l'organe d'actionnement (1) qu'à la carte à circuits imprimés (2).

4. Organe de commande selon la revendication 3, **caractérisé par le fait que** l'organe d'actionnement (1) s'engage derrière le tapis de commutation (26) et que, dans la position de repos de l'organe de commande, la partie conductible (25) de l'organe d'actionnement (1) est appliqué sur la couche (27) conduisant l'électricité du tapis de commutation (26).
